# EUROPEAN PATENT APPLICATION

(11) **EP 4 615 191 A1**
(43) Date of publication of application: **10.09.2025**
(21) Application number: 25159178.0
(22) Date of filing: 20.02.2025
(51) Int. Cl.: H10D 30/66, H10D 30/01, H10D 62/10

(54) **SEMICONDUCTOR ELECTRONIC DEVICE WITH EDGE TERMINATION REGION AND MANUFACTURING PROCESS**

(30) Priority: 06.03.2024 IT 202400004948
(71) Applicant: STMicroelectronics International N.V., 1228 Plan-les-Ouates, Geneva (CH)
(72) Inventor: SANFILIPPO, Delfo Nunziato, 95128 CATANIA (IT)
(74) Representative: Studio Torta S.p.A.

(57) **Abstract**

A semiconductor electronic device (100) has a semiconductor body (110) that has a first conductivity type (N), a front surface (110A) and a rear surface (110B) at a distance from the front surface along a first direction (Z). The semiconductor body also has a lateral edge (102). The device has an active area (103) which accommodates, in use, a conductive channel of the device; and an edge termination region (130) around the active area, between the active area and the lateral edge of the semiconductor body along a second direction (X) transversal to the first direction. The edge termination region has a plurality of doped portions (132) of a second conductivity type (P) different from the first conductivity type and arranged in the semiconductor body (110) at a distance from each other along the first direction (Z), or along the first direction (Z) and along the second direction (X).

## Description

### Technical Field

The present invention relates to a semiconductor electronic device, in particular a vertical-conduction device, with an edge termination region, and to the manufacturing process thereof.

### Background

As is known, semiconductor electronic devices (for example MOSFET transistors) used in power applications need to withstand high voltages, for example even higher than 400 V.

In power applications, a high breakdown voltage and a low on-state resistance are parameters desired in order to improve the electrical performances of electronic devices.

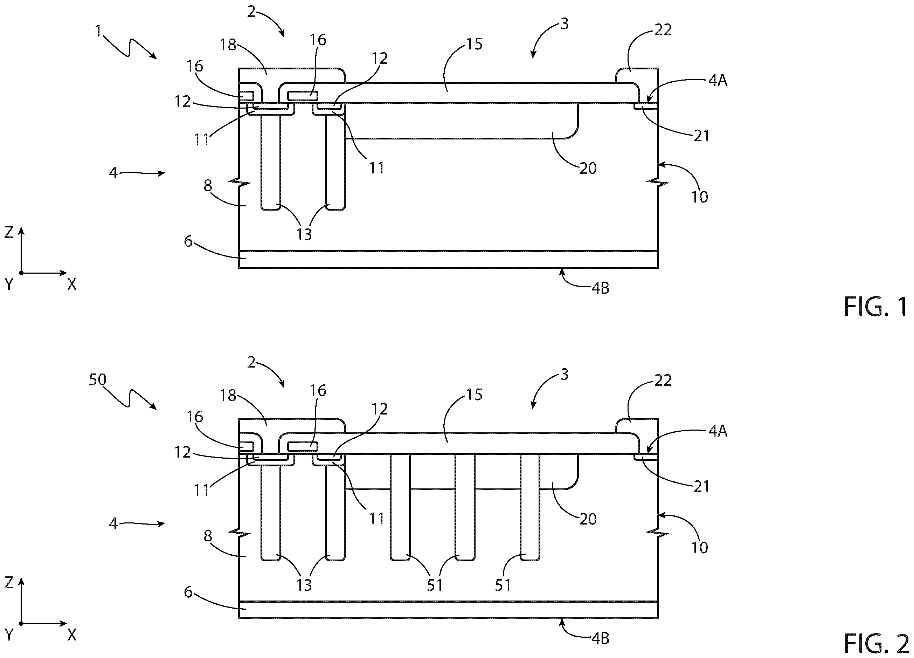

Figure 1 shows a known MOSFET device 1 based on silicon, for power applications, in a Cartesian reference system XYZ.

The MOSFET device 1 is a vertical-conduction device and has a super junction-type structure (based on a charge compensation principle) which allows the MOSFET device 1 to overcome the classic limits of silicon, that is to obtain a good trade-off between high breakdown voltage and low on-state resistance.

The MOSFET device 1 is formed in a die comprising an active area 2 and an edge region 3.

The MOSFET device 1 comprises a semiconductor body 4 of silicon, having a front surface 4A and a rear surface 4B, and of N-type. The semiconductor body 4 comprises a substrate 6 and an epitaxial region 8 grown on the substrate 6.

The active area 2, of which only a part is shown in Figure 1, is configured to accommodate, in use, a conductive channel of the MOSFET device 1.

The edge region 3 extends around the active area 2, in a peripheral portion of the die, between the active area 2 and an outer edge 10 of the semiconductor body 4.

The MOSFET device 1 comprises, in the active area 2, a plurality of surface body regions 11, of P-type, which extend, from the front surface 4A, inside the epitaxial region 8 along the Z axis.

The surface body regions 11 extend at a distance from each other along the X axis.

Source regions 12, of N-type, each extend inside a respective surface body region 11.

Deep body regions 13, of P-type, extend in depth into the epitaxial region 8, along the Z axis, each starting from a respective surface body region 11. The presence of the deep body regions 13 defines the superjunction structure of the MOSFET device 1.

An insulating region 15 extends onto the front surface 4A of the semiconductor body 4 and gate insulated regions 16 are arranged inside the insulating region 15, over the front surface 4A.

Each gate insulated region 16 is arranged between two adjacent surface body regions 11, partially overlying the surface body regions 11.

A conductive region 18 extends into openings of the insulating region 15, in contact with the source regions 12.

The edge region 3 comprises an edge termination region 20 of P-type which extends at the surface in the epitaxial region 8, starting from the front surface 4A, and has the shape of a ring surrounding the active area 2. The edge termination region 20 extends continuously along the X axis from the active area 2 towards the outer edge 10. The edge termination region 20 has a width along the X axis comprised between 50 µm and 200 µm.

The MOSFET device 1 also has an equipotential ring 21 of N-type, which extends at the surface in the epitaxial region 8, at the outer edge 10 of the semiconductor body 4, and a conductive region 22 which extends onto the front surface 4A in contact with the equipotential ring 21.

The superjunction structure allows high breakdown voltages of the MOSFET device 1 to be obtained, for example up to 1000 V and above. The presence of the ring region 20 contributes to increasing the breakdown voltage of the MOSFET device 1.

However, the presence of the ring region 20 requires additional manufacturing steps (lithography, implantation and diffusion) with respect to those leading to the formation of the surface 11 and deep 13 body regions. Accordingly, the MOSFET device 1 has high manufacturing costs.

Figure 2 shows another example of a MOSFET device 50, also a vertical-conduction and super junction-type device. The MOSFET device 50 has the same structure as the MOSFET device 1 of Figure 1; accordingly, common elements are indicated by the same reference numerals.

In the MOSFET device 50, the edge region 3 also comprises further edge termination regions forming a plurality of columns 51 of P-type which extend in depth into the semiconductor body 4 starting from the front surface 4A.

The columns 51 extend continuously along the Z axis, from the front surface 4A through the ring region 20 and the epitaxial region 8.

However, the MOSFET device 50 also has high manufacturing costs.

The aim of the present invention is to overcome the drawbacks of the prior art.

### Summary

According to the present invention, a semiconductor electronic device and a manufacturing process thereof are therefore provided, as defined in the attached claims.

### Brief Description of the Drawings

For a better understanding of the present invention, embodiments thereof are now described, purely by way of nonlimiting example, with reference to the attached drawings, wherein:
- Figure 1 shows a cross-section of a known MOSFET device;
- Figure 2 shows a cross-section of a further known MOSFET device;
- Figure 3 shows a top-plan view of a semiconductor electronic device, according to one embodiment of the present invention;
- Figure 4 shows a cross-section of the device of Figure 3, along a section line IV-IV of Figure 3;
- Figures 5A-5G show the device of Figure 4, in subsequent manufacturing steps, according to one embodiment;
- Figures 6 and 7 show cross-sections of semiconductor electronic devices, according to different embodiments of the present invention; and
- Figures 8 and 9 show top-plan views of semiconductor electronic devices, according to further embodiments of the present invention.

### Description of Embodiments

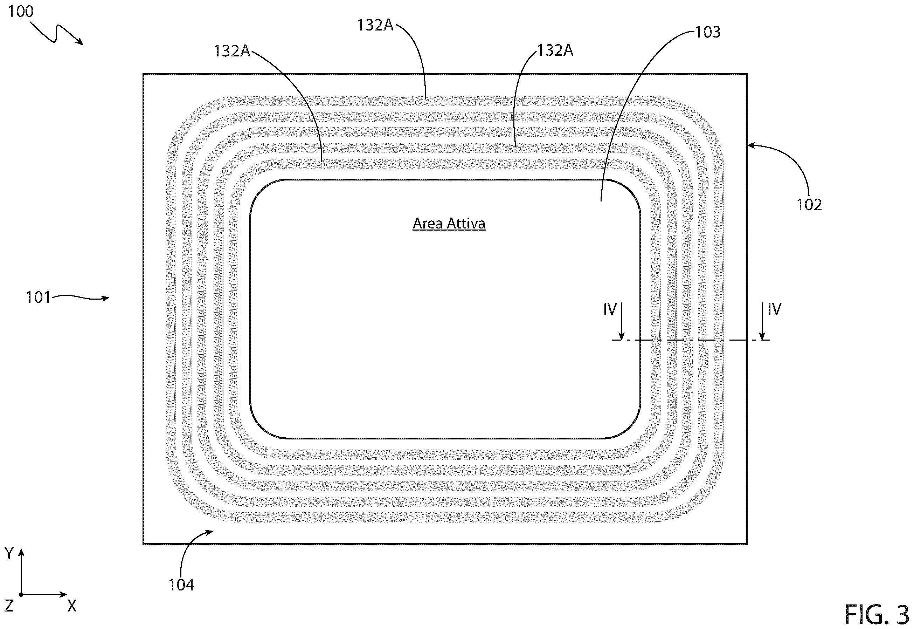

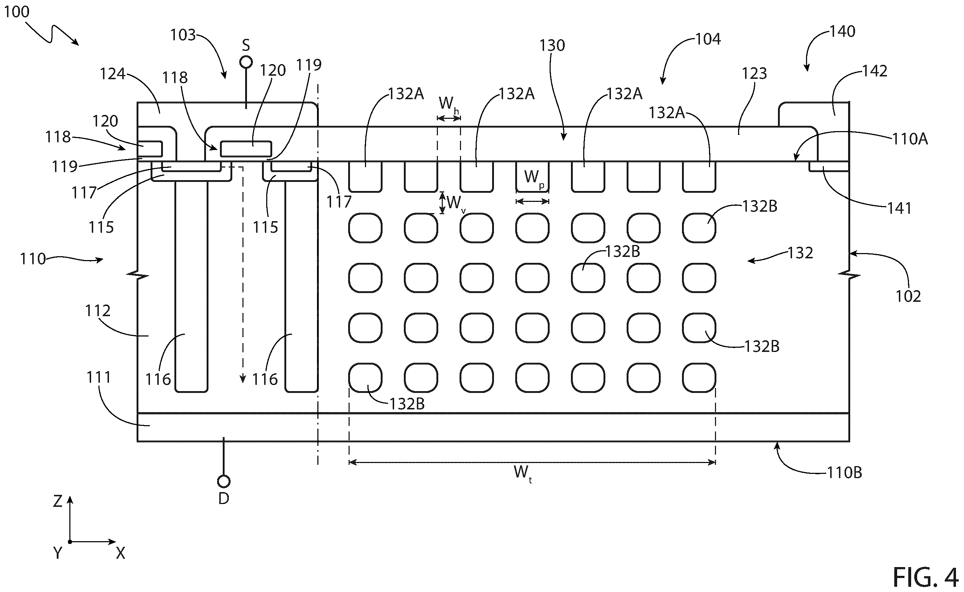

Figures 3 and 4 show a semiconductor electronic device, hereinafter simply referred to as device 100, in a Cartesian reference system XYZ having axes X, Y, Z orthogonal to each other.

The device 100 is a semiconductor device based on silicon; however, the device 100 may be a semiconductor device based on different material, for example silicon carbide or other simple or compound semiconductor material.

The device 100 is formed into a die 101 which may be obtained after a dicing step of a semiconductor wafer.

The die 101 comprises an edge 102 which physically delimits the die 101. In practice, the edge 102 is a lateral edge which laterally delimits the die 101.

The device 100 comprises an active area 103 and an edge region 104 which extends around the active area 103.

In particular, the edge region 104 extends in structural continuity with the active area 103.

Typically, the active area 103 may extend into a central portion of the die 101, and the edge region in a peripheral portion of the die 101.

In practice, the edge region 104 extends between the active area 103 and the edge 102 of the die 101 and is externally delimited by the edge 102.

The active area 103 is configured to accommodate, in use, a conductive channel of the device 100.

The edge region 104 may comprise functional elements for reducing or preventing crowding of the electric field lines outside the active area 103, as better described and illustrated hereinafter with reference to Figure 4. In practice, the edge region 104 is configured not to accommodate, in use, a conductive channel of the device 100.

As shown in the cross-section of Figure 4, the device 100 may be a MOSFET device, in particular a vertical-conduction MOSFET device, even more in particular a superjunction MOSFET device.

The device 100 may be an electronic device for power applications, in particular for high voltages, for example higher than 400 V.

Figure 4 shows only a portion of the active area 103, in particular a portion of the active area 103 in proximity to the edge region 104. The dash-dot line that separates the active area 103 from the edge region 104 is to be understood as qualitative.

The device 100 comprises a semiconductor body 110, in particular of silicon, or of silicon carbide or other semiconductor material, of N-type, and having a front surface 110A and a rear surface 110B at a distance from each other along the Z axis.

The front surface 110A forms the front side of the semiconductor body 110 and delimits it upwardly. The rear surface 110B forms the back side of the semiconductor body 110 and delimits it downwardly.

In practice, the front surface 110A and the rear surface 110B are opposite to each other along the Z axis.

The semiconductor body 110 also has a lateral edge which extends at a distance from the active area 103 along the X and Y axes. In practice, the lateral edge may physically delimit the semiconductor body 110, for example on planes transversal to those of the front and rear surfaces 110A, 110B. The lateral edge of the semiconductor body 110 may coincide with the edge 102 of the die 101, therefore it is indicated below with the same reference numeral.

In the embodiment shown, the semiconductor body 110 comprises a substrate 111 and a structural region 112 extending onto the substrate 111. For example, the structural region 112 may be grown epitaxially on the substrate 111; accordingly, hereinafter the structural region 112 is also referred to as epitaxial region 112.

The epitaxial region 112 forms, in the active area 103, a drift region of the device 100.

Substrate 111 and epitaxial region 112 may be of the same semiconductor material and have the same conductivity type (here N-type).

The substrate 111 may have a higher doping level than the epitaxial region 112.

The device 100 comprises, in the active area 103, surface body regions 115 of P-type; deep body regions 116 of P-type; source regions 117 of N-type; and gate regions 118.

For simplicity, in Figure 4, only two surface body regions 115, two deep body regions 116, two source regions 117, and two gate regions 118 are shown. However, it will be clear that the device 100 may comprise, in the active area 103, further surface body regions 115, deep body regions 116, source regions 117, and gate regions 118.

The surface body regions 115 extend from the front surface 110A into the semiconductor body 110, in particular into the epitaxial region 112, at a distance from each other along the X axis.

The source regions 117 extend, at least in part, each inside a respective surface body region 115.

The deep body regions 116 extend, along the Z axis, in depth into the semiconductor body 110, in particular into the epitaxial region 112, each starting from a respective surface body region 115.

The deep body regions 116 extend at a distance from the front surface 110A, in direct contact with the surface body regions 115.

In practice, the deep body regions 116 extend into the semiconductor body 110 to a depth, measured from the front surface 110A along the Z axis, greater than the depth, measured from the front surface 110A along the Z axis, of the surface body regions 115.

The deep body regions 116 may have a width (along the X axis in the section of Figure 4) smaller than the width (along the X axis in the section of Figure 4) of the surface body regions 115.

The gate regions 118 comprise a gate insulating portion 119 and a gate conductive portion 120 and extend onto the front surface 110A partially overlying the surface body regions 115 along the Z axis.

A drain region of conductive material, not shown here, extends at the rear surface 110B forming a drain terminal D of the device 100.

In practice, in use, the surface body regions 115 are configured to accommodate the conductive channel of the device 100, thus forming a conductive path extending along the Z axis through the semiconductor body 110, between the front surface 110A and the rear surface 110B, as indicated in an exemplary and schematic manner by a dashed arrow in Figure 4.

An insulating region 123 extends onto the front surface 110A of the semiconductor body 110, for example both in the active area 103 and in the edge region 104.

A conductive region 124 extends onto the semiconductor body 110, in electrical contact with the source regions 117. In practice, the conductive region 124 is a source contact region and forms a source terminal S of the device 100. For example, the conductive region 124 may extend through openings in the insulating region 123, throughout the thickness of the insulating region 123, to the front surface 110A.

The conductive region 124 may be used, for example at different sections of the device 100 not shown here, to also contact the surface body regions 115, so as to obtain a bodysource short circuit.

The device 100 comprises, in the edge region 104, an edge termination region 130 which extends inside the semiconductor body 110 around the active area 103.

The edge termination region 130 comprises a plurality of pockets 132 of P-type which extend into the semiconductor body 110, in particular inside the epitaxial region 112.

The edge termination region 130 may have a width Wₜ, measured along a direction (X axis in the section of Figure 4) extending between the active area and the lateral edge 102, comprised for example between 50 µm and 200 µm. Greater values of the width Wₜ may be useful for the device 100 to be capable of operating at high voltages.

In practice, the width Wₜ may be defined as the width, for example the maximum width, occupied as a whole by the pockets 132 inside the semiconductor body 110, between the active area 103 and the lateral edge 102.

The pockets 132 may have a doping level comprised, for example, between 5·10¹⁵ at/cm³ and 5·10¹⁷ at/cm³, in order to maximize the breakdown voltage.

The pockets 132 extend at a distance from each other along the Z axis. For example, the distance Wᵥ between two adjacent pockets 132 along the Z axis may be comprised between 3 µm and 8 µm.

The pockets 132 also extend at a distance from each other along the X axis. For example, the distance Wₕ between two adjacent pockets 132 along the X axis may be comprised between 2 µm and 6 µm.

The pockets 132 may each have a width Wₚ, along the X axis, comprised for example between 1 µm and 10 µm.

In this embodiment, the pockets 132 are distributed in the semiconductor body 110 such that the edge termination region 130 has a P-type pocket density (number of pockets per unit area or unit volume), at least as a first approximation (that is, except for process variability), uniform inside the width Wₜ. In practice, the pockets 132 are all arranged, at least as a first approximation (that is, except for process variability), at the same mutual distance Wₕ along the X axis and Wᵥ along the Z axis, and have at least as a first approximation the same width Wₚ.

In detail, the plurality of pockets 132 comprise surface pockets 132A, which extend into the semiconductor body 110 at the front surface 110A, and deep pockets 132B which extend into the semiconductor body 110 at a distance from the front surface 110A.

The surface pockets 132A extend starting from the front surface 110A towards the inside of the semiconductor body 110, in particular towards the inside of the epitaxial region 112.

The surface pockets 132A extend at a distance from each other along the X axis. In particular, the surface pockets 132A extend, at least as a first approximation (that is, except for process variability), all at the same distance from each other along the X axis.

The deep pockets 132B extend into the semiconductor body 110, in particular into the epitaxial region 112, at a distance from the front surface 110A of the semiconductor body 110.

The deep pockets 132B extend at a distance from each other along the X axis and along the Z axis.

In this embodiment, the deep pockets 132B are arranged in groups extending along the Z axis each underneath a respective surface pocket 132A.

In particular, in the example of Figure 4, four deep pockets 132B are arranged underneath each surface pocket 132A.

In detail, in the embodiment of Figure 4, the deep pockets 132B are aligned with each other along the Z axis and are also aligned along the Z axis with the respective surface pocket 132A. However, the pockets 132 may face each other along the Z axis in whole or in part.

The uniform distribution of the deep pockets 132B, in particular the fact of having the same mutual distance Wₕ along the X axis and the same mutual distance Wᵥ along the Z axis, may ensure greater simplicity in the design and manufacturing of the device 100.

As shown in Figure 3, the surface pockets 132A extend continuously around the active area 103. In other words, the surface pockets 132A have a substantially circular shape and form a plurality of concentric rings which completely surround the active area 103.

The deep pockets 132B may have, in plan view (e.g., on planes parallel to the XY plane), equal or different shape with respect to the surface pockets 132A.

According to one embodiment, the deep pockets 132B (all or only some of them) may also extend continuously around the active area 103; this may allow the device 100 to obtain, in use, a high breakdown voltage.

The device 100 may comprise, optionally, an end region 140 arranged in the edge region 104 at the outer edge 102.

The end region 140 comprises a doped region 141 of N-type which extends into the semiconductor body 110, at the front surface 110A; and a conductive region 142 which extends onto the front surface 110A in electrical contact with the doped region 141. The end region 140 may have the function of forming an equipotential ring with the drain terminal of the device 100, on the outer edge 102 of the die 101.

The Applicant has verified that the plurality of pockets 132 that form the edge termination region 130, at a distance from each other along the Z axis, allow, in use, a high breakdown voltage of the device 100 and therefore excellent electrical performance to be obtained.

In particular, the fact that the pockets 132 extend to a high depth into the semiconductor body 110, for example between 20 µm and 80 µm, from the front surface 110A, may ensure that the breakdown voltage of the device 100 is further increased.

In addition, the Applicant has verified that the fact that the pockets 132 extend, along the X axis, at a distance from each other along the X axis, contributes to increasing the electrical robustness, in use, of the device 100. For example, the device 100 may have in use high breakdown voltages, higher than or equal to 1000 V.

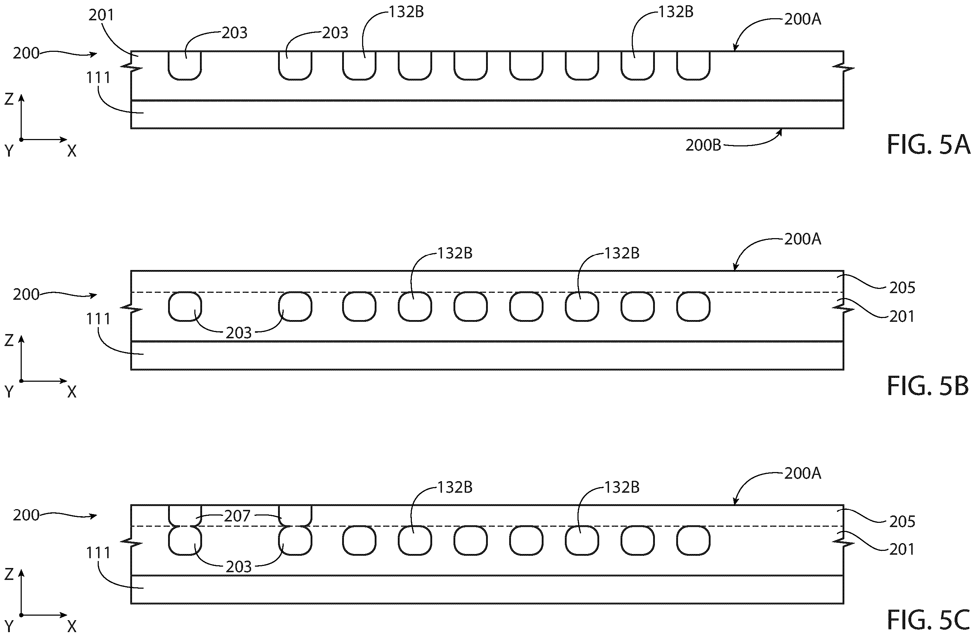

Furthermore, the fact that the pockets 132 extend at a distance from each other along the X axis also allows the manufacturing costs of the device 100 to be decreased, in particular if the device 100 is a super junction MOSFET device. In fact, as also discussed in detail below with reference to Figures 5A-5G, the distance along the X axis, allows to avoid the use of an additional mask for the formation of a ring region which extends continuously along the X axis, as instead discussed for the known devices 1 and 50 of Figures 1 and 2.

Hereinafter, with reference to Figures 5A-5G, manufacturing steps of the device 100 are shown, with reference to the cross-section shown in Figure 4.

In Figure 5A, a wafer 200 of silicon is provided having a front surface 200A and a rear surface 200B opposite to the front surface 200A parallel to the Z axis; alternatively, the wafer 200 may be of a different semiconductor material such as for example silicon carbide or other simple or compound semiconductor material.

The wafer 200 comprises the substrate, again indicated by 111, on which an epitaxial layer 201 has been grown.

The epitaxial layer 201 and the substrate 111 are of the same material (silicon); however, they may be made of different materials.

The epitaxial layer 201 and the substrate 111 have the same conductivity type, here N-type.

The epitaxial layer 201 forms the front surface 200A of the wafer 200.

Furthermore, doped portions 203 of P-type which will form the deep body regions 116, and P-type doped portions which will form the deepest row of the deep pockets 132B and therefore again indicated by 132B have already been formed, in the wafer 200.

For example, the doped portions 203, 132B may be formed by implanting P-type doping species into the epitaxial layer 201, for example by using a lithographic mask to selectively implant the P-type doping species into the desired areas.

Subsequently, Figure 5B, an epitaxial layer 205 is grown on the epitaxial layer 201. The epitaxial layer 205 is of the same material (here silicon) as the epitaxial layer 201; however, it may be of different material.

The epitaxial layer 205 forms a new front surface of the wafer 200, again indicated by 200A for simplicity. For clarity, in Figure 5B, a dashed line divides the epitaxial layer 205 from the epitaxial layer 201.

In Figure 5C, doped portions 207 are formed in the epitaxial layer 205, over and in contact with the doped portions 203. For example, the doped portions 207 may be formed by implanting P-type doping species into the epitaxial layer 205, for example by using a lithographic mask to selectively implant the P-type doping species into the desired areas.

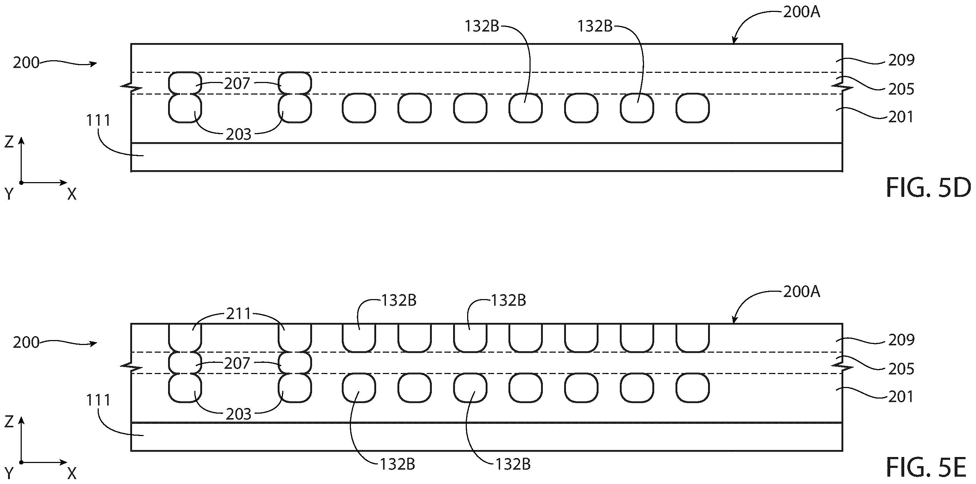

In Figure 5D, an epitaxial layer 209 is grown on the front surface 200A, on the epitaxial layer 205.

The epitaxial layer 209 is of the same material (here silicon) as the epitaxial layer 205; however, it may be of different material.

The epitaxial layer 209 forms a new front surface of the wafer 200, again indicated by 200A for simplicity. For clarity, in Figure 5D, a dashed line divides the epitaxial layer 205 from the epitaxial layer 209.

In Figure 5E, doped portions 211 of P-type are formed in the epitaxial layer 209, over and in contact with the doped portions 207. Furthermore, P-type doped portions which will form a further row of deep pockets 132B, therefore again indicated by 132B, are also formed in the epitaxial layer 209.

For example, the doped portions 211, 132B may be formed by implanting P-type doping species into the epitaxial layer 209, for example by using a lithographic mask to selectively implant the P-type doping species into the desired areas.

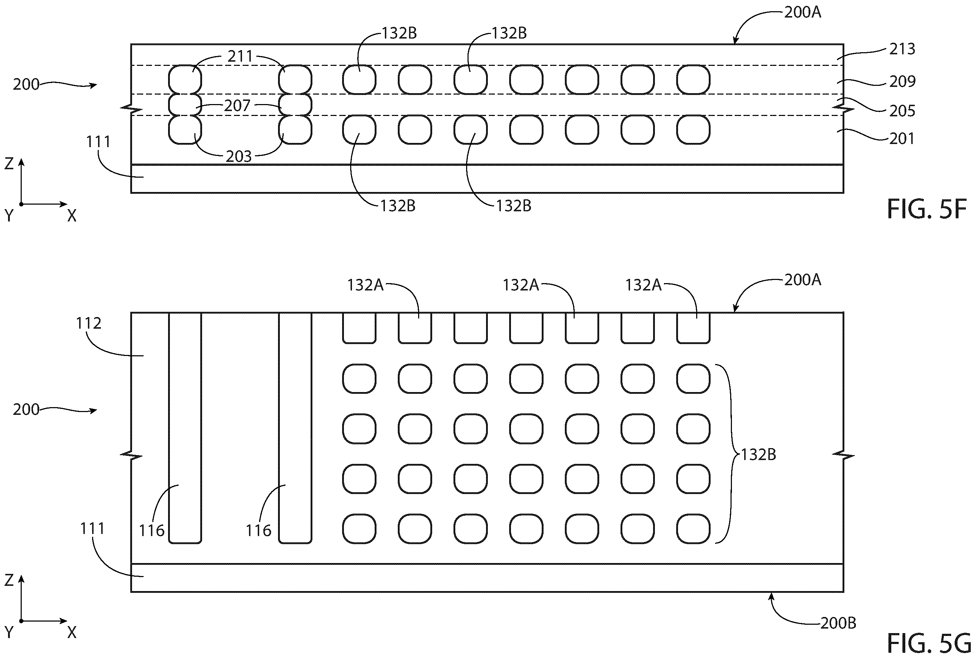

In Figure 5F, an epitaxial layer 213 is grown on the front surface 200A, on the epitaxial layer 209. The epitaxial layer 213 is of the same material (here silicon) as the epitaxial layer 209; however, it may be of different material.

The epitaxial layer 213 forms a new front surface of the wafer 200, again indicated by 200A for simplicity. For clarity, in Figure 5F, a dashed line divides the epitaxial layer 213 from the epitaxial layer 209.

Following the growth of Figure 5F, what has been described with reference to Figures 5C to 5E is repeated in sequence up to the formation of the surface pockets 132A of the edge termination region 130 and the deep body regions 116 (Figure 5G).

Furthermore, in Figure 5G, the succession of epitaxial layers grown on top of each other forms the epitaxial region 112 of the device 100.

In practice, the pockets 132 and the deep body regions 116 may be formed simultaneously by alternating epitaxial growth steps and doping species implantation steps.

The steps of Figures 5C-5E are repeated a number of times that depends on the desired thickness of the epitaxial region 112, the desired thickness of the deep body regions 116, and the desired number of pockets 132 in the edge termination region 130.

One or more annealing steps may be performed to activate the pockets 132A, 132B and the deep body regions 116.

Subsequently, in a manner not shown here, the remaining regions of the device 100 described with reference to Figure 4 may be formed, including the surface body regions 115, the source regions 117 and the gate regions 118.

Finally, per se known manufacturing steps follow, such as dicing of the wafer 200 and formation of the electrical contacts, leading to the formation of the device 100.

The described manufacturing process allows the manufacturing costs of the device 100 to be reduced, in particular when the device 100 is a MOSFET device with a superjunction structure. In fact, the pockets 132 of the edge termination region 130 may be formed with the same masks and the same implantation steps used for the formation of the deep body regions 116, without additional dedicated lithography and implantation steps.

Furthermore, the described process may also have reduced complexity and execution times compared to the manufacturing processes of the known devices of Figures 1 and 2.

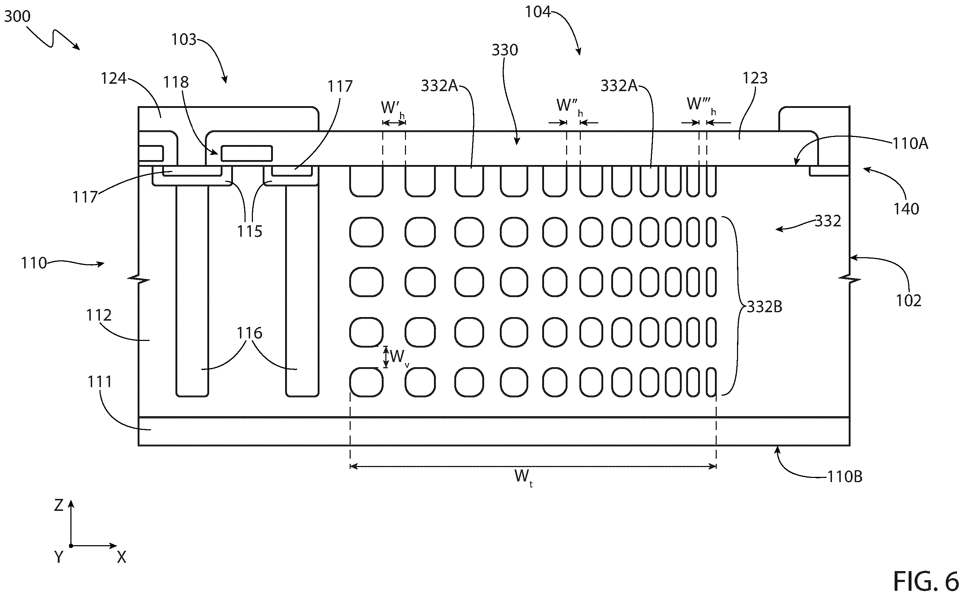

Figure 6 shows a different embodiment of the present electronic device, indicated here by 300. The electronic device 300 has a general structure similar to that of the device 100; accordingly, elements in common are indicated by the same reference numerals and are not further described in detail.

The device 300 is also a vertical-conduction MOSFET device of the super junction type.

In detail, the device 300 comprises the semiconductor body 110 and has, in the active area 103, the surface body regions 115, the deep body regions 116, the source regions 117 and the gate regions 118.

The device 300 comprises, in the edge region 104, an edge termination region 330 which extends inside the semiconductor body 110 around the active area 103.

The edge termination region 330 also here comprises a plurality of pockets 332 of an opposite conductivity type (P) with respect to that of the semiconductor body 110 (N), including surface pockets 332A and deep pockets 332B, which extend into the semiconductor body 110, in particular inside the epitaxial region 112.

The edge termination region 330 may have the width Wₜ described with reference to the device 100.

The pockets 332 may have, around the active area 103, in plan view on planes parallel to the XY plane, the same trend as discussed with reference to the pockets 132 of Figure 3. For example, the pockets 332 may each have a circular shape around the active area 103, in particular forming concentric circles with each other.

Compared to what has been shown and described for the device 100, the pockets 332 may have, at the surface, variable spacing and widths.

The pockets 332 are distributed in the semiconductor body 110 in such a way that the edge termination region 330 has a non-uniform P-type pocket density (number of pockets per unit area or unit volume) inside the width Wₜ.

In detail, the pockets 332 may have increasing density moving parallel to the X axis from the active area 103 towards the outer edge 102 of the die 101. For example, the width of the pockets 332 and/or the distance along the X axis between two adjacent pockets 332 may have a decreasing trend moving away from the active area 103 parallel to the X axis and towards the outer edge 102.

For example, as shown in Figure 6, two adjacent pockets 332 along the x axis may be arranged from each other at a distance W'ₙ in proximity to the active area 103, a distance W"ₕ at a central portion of the edge termination region 330, and a distance W‴ₕ in proximity to the edge 102, where W‴ₕ < W"ₕ < W'ₕ.

For example, the distance W'ₕ may be comprised between 3 µm and 8 µm. For example, the distance W"ₕ may be comprised between 2 µm and 7 µm. For example, the distance W‴ₕ may be comprised between 1 µm and 6 µm.

The edge termination region 330 allows the device 300 to have, in use, a high breakdown voltage.

In particular, the fact that the density of the pockets 332 is not uniform in the edge termination region 330, and even more in particular the density is greater at greater distances from the active area 103, may ensure high electrical performances.

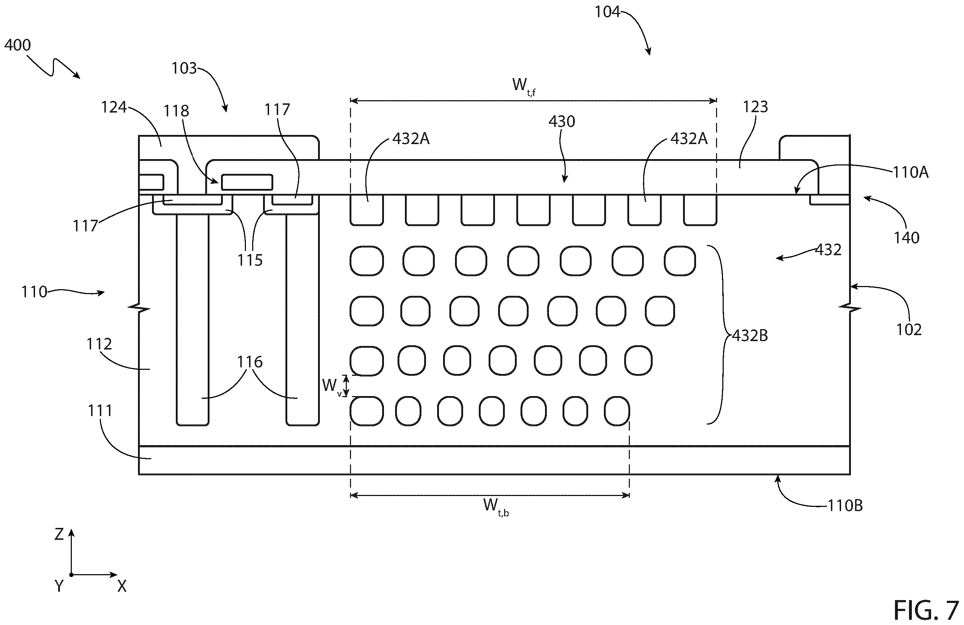

Figure 7 shows a further embodiment of the present electronic device, indicated here by 400. The electronic device 400 has a general structure similar to that of the device 100; accordingly, elements in common are indicated by the same reference numerals and are not further described in detail.

The device 400 is also a vertical-conduction MOSFET device of the super junction type.

In detail, the device 400 comprises, in the active area 103, the surface body regions 115, the deep body regions 116, the source regions 117 and the gate regions 118.

The device 400 comprises, in the edge region 104, an edge termination region 430 which extends inside the semiconductor body 110 around the active area 103.

The edge termination region 430 comprises a plurality of pockets 432, also here of an opposite conductivity type (P) with respect to that of the semiconductor body 110 (N-type), extending into the semiconductor body 110.

The pockets 432 may have, around the active area 103, in plan view on planes parallel to the XY plane, the same trend as discussed with reference to the pockets 132 of Figure 3, for example so as to each form a circle around the active area 103. The circles formed by the pockets 332B of each row may also here be concentric with each other.

In detail, the plurality of pockets 432 includes surface pockets 432A extending at the front surface 110A, and deep pockets 432B extending at a distance from the front surface 110A.

The edge termination region 430 has a width, measured along a direction which extends between the active area 103 and the outer edge 102 (X axis in Figure 7), variable as a function of the depth in the semiconductor body 110. In particular, the width is decreasing moving from the front surface 110A towards the rear surface 110B along the Z axis.

In detail, at the front surface 110A, the surface pockets 432A define an upper width W_{t,f} of the edge termination region 430, comprised for example between 50 µm and 200 µm.

The deep pockets 432B define, in depth in the epitaxial region 112, a rear width W_{t,b} of the edge termination region 430, comprised for example between 30 µm and 120 µm.

The upper width W_{t,f} is greater than the rear width W_{t,b}; in particular the upper width W_{t,f} defines a maximum width of the edge termination region 430 and the rear width W_{t,b} defines a minimum width of the edge termination region 430.

Furthermore, the pockets 432 may be arranged in such a way that the edge termination region 430 has a non-uniform density of the pockets 432, for example greater at greater depths within the epitaxial region 112 from the front surface 110A. This may ensure a high breakdown voltage, in use, of the device 400.

For example, moving from the front surface 110A towards the rear surface 110B parallel to the Z axis, the pockets 432 may have a width, measured along the X axis, that is decreasing.

Electrical simulations performed by the Applicant have verified that the decreasing trend of the width of the edge termination region 430 may be useful to ensure, in use, excellent electrical performances of the device 400.

In practice, with reference to the devices 100, 300, 400, the fact that the respective edge termination region 130, 330, 430 is formed by a plurality of pockets 132, 332, 432 having a conductivity type different from that of the semiconductor body 110 and arranged at a distance from each other along the Z axis or along both the Z axis and along the X axis, gives a high design versatility of the edge termination region. The present electronic device may therefore be adapted to a high variety of applications.

It is also clear to the person skilled in the art that the manufacturing steps described with reference to Figures 5A-5G may be adapted for the manufacturing of the devices 300, 400.

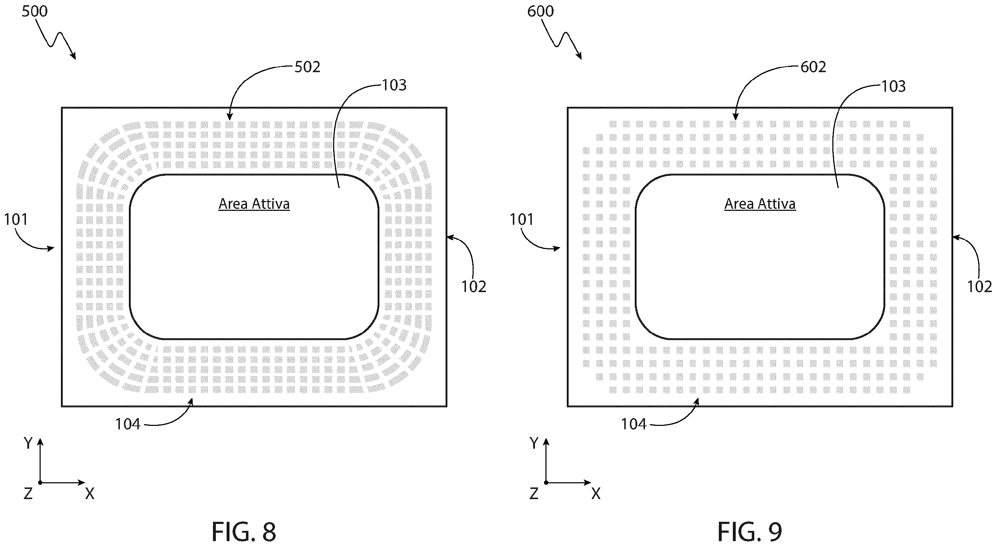

Figures 8 and 9 show further embodiments of the present semiconductor electronic device, indicated by 500 and 600, respectively.

The devices 500 and 600 comprise, in the edge region 104 around the active area, an edge termination region having P-type pockets (indicated by 502 and 602, respectively).

The pockets 502, 602 may have a distribution in the semiconductor body 110 that is equal to or different from what has been discussed for the pockets 132 (Figure 4), 332 (Figure 6) and 432 (Figure 7).

In particular, the devices 500 and 600 differ from the device 100 of Figures 3 and 4 in the distribution of the pockets 502, 602 around the active area 103.

In detail, in the devices 500 and 600, the pockets 502, 602 extend discontinuously around the active area 103, thus forming a plurality of portions separated from each other.

The discontinuous distribution of the pockets 502 or 602 around the active area 103 may simplify the design step, in particular of the lithography masks, of the devices 500 and 600.

Finally, it is clear that modifications and variations may be made to the semiconductor electronic devices and the manufacturing processes thereof described and illustrated herein without thereby departing from the scope of the present invention, as defined in the attached claims.

For example, the surface pockets and/or the deep pockets of the edge termination regions may be (all or only some of them) floating or have dedicated regions for biasing to a specific electric potential. In particular, the surface pockets and the deep pockets may be (for example, all) floating; in this case, the actual potential of the pockets may be established in the design step through appropriate sizing as a function of the specific application. Furthermore, using floating pockets allows the manufacturing of the device to be simplified.

For example, the edge termination region may have a different pocket number and distribution than described.

With reference to Figure 7, the non-uniform density of deep pockets along axis Z may be obtained in a different manner than what described above, for example by deep pockets having different dimensions one from the other. For example, the edge termination region may have the same width at the surface (W_{t,f}) as deep at the back (W_{t,b}), and the non-uniform density may be obtained by pockets of different dimensions one with the other.

According to one or more embodiments, the edge termination region may have only deep doped portions (e.g., pockets 132B, 332B, 432B) and not have superficial doped portions (e.g., pockets 132A, 332A, 432A). In other words, the edge termination region may be devoid of the superficial doped portions (e.g., pockets 132A, 332A, 432A) that extend at the front surface 110A. This may allow to reduce the number of manufacturing steps with respect to the process described above, with consequent reduction of the manufacturing costs of the present electronic device.

For example, the deep body regions and/or the doped pockets of the edge termination region may be manufactured, alternatively or in addition to subsequent steps of epitaxial growth and implantation of doping species, by forming trenches in the wafer 200 and filling the trenches with doped semiconductor material.

For example, the gate regions 118 may be of the trench type, i.e. extending along the Z axis into the semiconductor body 110.

For example, the active area 103 may also accommodate elementary cells of devices other than a MOSFET, according to the specific application of the semiconductor electronic device.

For example, the present invention also applies to a semiconductor electronic device other than a vertical-conduction MOSFET of the super junction-type, such as for example lateral conduction MOSFETs, vertical-conduction MOSFETs and not of the superjunction-type, or devices other than a MOSFET such as trenchFETs, diodes, triristors, MESFETs, MISFETs, IGBTs, etc.

The conductivity types, P and N, may be reversed with respect to what has been discussed above. For example, the semiconductor body may be of a P-type and the pockets of the edge termination region may be of an N-type.

Finally, the different embodiments described and illustrated above may be combined to provide further solutions. For example, the edge termination region may have a density of doped portions that is non-uniform both along a horizontal direction (e.g., axis X and/or Y) and along a vertical direction (e.g., axis Z).

## Claims

1. A semiconductor electronic device (100; 300; 400; 500; 600) comprising:
a semiconductor body (110) having a first conductivity type (N), a front surface (110A) and a rear surface (110B) extending at a distance from the front surface along a first direction (Z), the semiconductor body also having a lateral edge (102);
an active area (103) configured to accommodate, in use, a conductive channel of the semiconductor electronic device; and
an edge termination region (130; 330; 430) extending around the active area, between the active area and the lateral edge of the semiconductor body along a second direction (X) transversal to the first direction (Z),
wherein the edge termination region comprises a plurality of doped portions (132; 332; 432; 502; 602) having a second conductivity type (P) different from the first conductivity type and arranged in the semiconductor body (110) at a distance from each other along the first direction (Z), or along the first direction (Z) and along the second direction (X).

2. The semiconductor electronic device according to the preceding claim, wherein the plurality of doped portions comprises surface doped portions (132A; 332A; 432A) extending into the semiconductor body starting from the front surface (110A), at a distance from each other along the second direction (X).

3. The semiconductor electronic device according to claim 1 or 2, wherein the plurality of doped portions comprises deep doped portions (132B; 332B; 432B) extending into the semiconductor body at a distance from the front surface (110A) and at a distance from each other along the second direction (X) and/or along the first direction (Z).

4. The semiconductor electronic device according to any of the preceding claims, wherein the doped portions face each other at least in part, in particular aligned with each other, along the first direction (Z).

5. The semiconductor electronic device according to any of the preceding claims, wherein the edge termination region (130) has a uniform density of doped portions.

6. The semiconductor electronic device according to any of claims 1-4, wherein the edge termination region (330; 430) has a non-uniform density of doped portions.

7. The semiconductor electronic device according to the preceding claim, wherein the edge termination region (330) has, in proximity to the active area (103), a first density of doped portions and, in proximity to the lateral edge (102) of the semiconductor body, a second density of doped portions which is greater than the first density.

8. The semiconductor electronic device according to any of the preceding claims, wherein the edge termination region (330; 430) has a density of doped portions increasing along the second direction (X), from the active area (130) towards the lateral edge (102).

9. The semiconductor electronic device according to any of the preceding claims, wherein the edge termination region (330; 430) has a density of doped portions increasing along the first direction (Z) from the front surface (110A) towards the rear surface (110B).

10. The semiconductor electronic device according to any of the preceding claims, wherein the edge termination region (430) has a width along the second direction (X) that is decreasing along the first direction (Z) from the front surface (110A) towards the rear surface (110B).

11. The semiconductor electronic device according to any of the preceding claims, wherein the doped portions (132; 332; 432) each have a width along the second direction (X) comprised between 1 µm and 10 µm.

12. The semiconductor electronic device according to any of the preceding claims, wherein the device is a vertical-conduction device, in particular a MOSFET device.

13. The semiconductor electronic device according to the preceding claim, wherein the device is a superjunction MOSFET device, in particular comprising at least one deep body region (116) extending into the active area (103) at a distance from the front surface (110A) along the first direction (Z) .

14. A process for manufacturing a semiconductor electronic device, comprising:
providing a wafer (200) of semiconductor material having a first conductivity type (N), a front surface (200A) and a rear surface (200B) at a distance from the front surface along a first direction (Z), the wafer further having a lateral edge (102);
forming an active area (103) configured to accommodate, in use, a conductive channel of the semiconductor electronic device; and
forming an edge termination region (130; 330; 430) extending around the active area, between the active area and the lateral edge of the wafer along a second direction (X) transversal to the first direction (Z),
wherein forming an edge termination region comprises forming a plurality of doped portions (132; 332; 432; 502; 602), having a second conductivity type (P) different from the first conductivity type, in the semiconductor body and at a distance from each other along the first direction (Z), or along the first direction and along the second direction (X) .

15. The manufacturing process according to the preceding claim, wherein forming an edge termination region comprises performing at least once:
growing at least one epitaxial layer (201, 209) on the front surface (200A) of the wafer; and
forming the doped portions in the at least one epitaxial layer.

16. The manufacturing process according to claim 14 or 15, wherein the semiconductor electronic device comprises forming, in the wafer, at least one deep body region (116) having the second conductivity type (P), the deep body regions being formed, at least in part, simultaneously with the doped portions of the edge termination region.
